# EUROPEAN PATENT APPLICATION

(11) **EP 4 641 238 A1**
(43) Date of publication of application: **29.10.2025**
(21) Application number: 23914986.7
(22) Date of filing: 21.12.2023
(51) Int. Cl.: G01R 31/56, G01R 31/52, G01R 31/396, G01R 31/392, G01R 31/3835, G01R 31/385

(54) **DISCONNECTION DETECTION DEVICE AND METHOD FOR OPERATING SAME**

(30) Priority: 05.01.2023 KR 20230001961
(71) Applicant: LG Energy Solution, Ltd., Seoul 07335 (KR)
(72) Inventor: YOON, Du Seong, Daejeon 34122 (KR); LEE, Bom Jin, Daejeon 34122 (KR); JEON, Chul Min, Daejeon 34122 (KR)
(74) Representative: Plasseraud IP
(86) International application number: PCT/KR2023/021265
(87) International publication number: WO 2024/147526

(57) **Abstract**

A disconnection detection device according to one embodiment disclosed herein includes an acquisition unit configured to acquire charging profiles of a battery acquired from different C-rates, a detection unit configured to acquire relationship data between voltage-capacity changes based on the charging profiles and detect two or more peak values for each of the C-rates from the relationship data, a comparison unit configured to compare a first peak value among the two or more peak values for each of the C-rates with a first reference peak value for each of the C-rates and compare a second peak value among the two or more peak values for each of the C-rates with a second reference peak value for each of the C-rates, and a determination unit configured to determine whether the battery is disconnected based on a result of the comparison of the comparison unit.

## Description

### [TECHNICAL FIELD]

### CROSS-REFERENCE TO RELATED APPLICATION

This application claims priority to and the benefit of Korean Patent Application No. 10-2023-0001961 filed in the Korean Intellectual Property Office on January 5, 2023, the entire contents of which are incorporated herein by reference.

### TECHNICAL FIELD

Embodiments disclosed herein relate to a disconnection detection device and a method of operating the same.

### [BACKGROUND ART]

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, lithium-ion batteries have an advantage of having much higher energy density than conventional Ni/Cd batteries and Ni/MH batteries. In addition, the lithium-ion batteries may be made smaller and lighter and thus are used as a power source for mobile devices and recently, are attracting attention as next-generation energy storage media due to the expansion of the range of usage to a power source for electric vehicles.

These batteries include electrodes (a positive electrode and a negative electrode). When the electrode (in particular, the negative electrode) of the battery is disconnected, a short circuit may occur between the electrodes of the battery. For example, when the negative electrode of the battery is short-circuited, lithium may precipitate on the disconnected negative electrode, there causing a short circuit between the positive electrode and the negative electrode. When the short circuit occurs between the electrodes of the battery, risk of explosion of the battery increases..

### [DISCLOSURE]

### [TECHNICAL PROBLEM]

It is important to determine whether an electrode (in particular, a negative electrode) of the battery is short-circuited to reduce risk of explosion of such a battery.

To this end, conventionally, a method of diagnosing whether an electrode of a battery is short-circuited by disassembling the battery has been suggested. However, when the battery is disassembled, a problem that much man-power and time consume has occurred.

Therefore, there is a need for research on a method capable of diagnosing whether an electrode of a battery is disconnected without disassembling the battery.

The objects of embodiments disclosed herein are not limited to the above-described objects, and other objects that are not mentioned will be able to be clearly understood by those skilled in the art from the following descriptions.

### [TECHNICAL SOLUTION]

A disconnection detection device according to one embodiment disclosed herein includes an acquisition unit configured to acquire charging profiles of a battery acquired from different C-rates, a detection unit configured to acquire relationship data between voltage-capacity changes based on the charging profiles and detect two or more peak values for each of the C-rates from the relationship data, a comparison unit configured to compare a first peak value among the two or more peak values for each of the C-rates with a first reference peak value for each of the C-rates and compare a second peak value among the two or more peak values for each of the C-rates with a second reference peak value for each of the C-rates, and a determination unit configured to determine whether the battery is disconnected based on a result of the comparison of the comparison unit, wherein the first reference peak value increases as the C-rates increase, and the second reference peak value decreases as the C-rates increase.

In one embodiment, when the first peak value for each of the C-rates is smaller than the first reference peak value for each of the C-rates and the second peak value for each of the C-rates is higher than the second reference peak value for each of the C-rates, the determination unit may determine that a disconnection has occurred in the battery,

In one embodiment, the first peak value may be a parasitic peak value, and the second peak value may be a peak value other than the parasite peak value.

In one embodiment, the two or more peak values for each of the C-rates may further include a third peak value, the comparison unit may additionally compare the third peak value among the two or more peak values for each of the C-rates with a third reference peak value for each of the C-rates, the determination unit may determine whether the battery is disconnected additionally based on a result of additional comparison between the third peak value and the third reference peak value of the comparison unit, and the third reference peak value may decrease as the C-rates increase.

In one embodiment, when the result of the comparison represents a disconnection of the battery and the third peak value for each of the C-rates is greater than the third reference peak value for each of the C-rates, the determination unit may determine that a disconnection has occurred in the battery.

In one embodiment, the first peak value may be acquired in a first C-rate range, and the second peak value may be acquired in a second C-rate range including the first C-rate range.

A disconnection detection method according to one embodiment disclosed herein includes an operation of acquiring charging profiles of a battery acquired from different C-rates, an operation of acquiring relationship data between voltage-capacity changes based on the charging profiles, an operation of detecting two or more peak values for each of the C-rates from the relationship data, an operation of comparing a first peak value among the two or more peak values for each of the C-rates with a first reference peak value for each of the C-rates and comparing a second peak value among the two or more peak values for each of the C-rates with a second reference peak value for each of the C-rates, and an operation of determining whether the battery is disconnected based on a result of the comparison by the operation of comparing, wherein the first reference peak value increases as the C-rates increase, and the second reference peak value decreases as the C-rates increase.

In one embodiment, when the first peak value for each of the C-rates is smaller than the first reference peak value for each of the C-rates and the second peak value for each of the C-rates is higher than the second reference peak value for each of the C-rates, the operation of determining may determine that a disconnection has occurred in the battery,

In one embodiment, the first peak value may be a parasitic peak value, and the second peak value may be a peak value other than the parasite peak value.

In one embodiment, the two or more peak values for each of the C-rates may further include a third peak value, the operation of comparing may include comparing the third peak value among the two or more peak values for each of the C-rates with a third reference peak value for each of the C-rates, the operation of determining may include determining whether the battery is disconnected additionally based on a result of the additional comparison between the third peak value and the third reference peak value, and the third reference peak value may decrease as the C-rates increase.

In one embodiment, when the result of the comparison represents a disconnection of the battery and the third peak value for each of the C-rates is greater than the third reference peak value for each of the C-rates, the operation of determining may include determining that a disconnection has occurred in the battery.

In one embodiment, the first peak value may be acquired in a first C-rate range, and the second peak value may be acquired in a second C-rate range including the first C-rate range.

### [ADVANTAGEOUS EFFECTS]

The disconnection detection device and the method of operating the same according to various embodiments disclosed herein, it is possible to determine whether a battery has been short-circuited based on a charging profile of the battery without disassembling the battery.

The effects of the disconnection detection device and the method of operating the same according to the disclosure of the present document are not limited to the above-described effects, and other effects that are not mentioned will be able to be clearly understood by those skilled in the art according to the disclosure of the present document.

### [DESCRIPTION OF DRAWINGS]

FIG. 1 is a block diagram of a disconnection detection device according to one embodiment of the present disclosure.
FIG. 2 illustrates a capacity change (dQ/dV) profile according to a voltage according to one embodiment of the present disclosure.
FIG. 3 illustrates a first peak value and a second peak value of the capacity change (dQ/dV) profile according to a C-rate according to one embodiment of the present disclosure.
FIG. 4 illustrates a third peak value of a capacity differential (dQ/dV) profile according to the C-rate according to one embodiment of the present disclosure.
FIG. 5 is a flowchart illustrating a method of operating a disconnection detection device according to one embodiment of the present disclosure.

In the description of the drawings, the same or similar reference numerals may be used for the same or similar components.

### [MODE FOR INVENTION]

Hereinafter, embodiments of the present invention will be described with reference to the accompanying drawings. However, it should be understood that this is not intended to limit the present invention to specific embodiments and includes various modifications, equivalents, and/or alternatives of the embodiments of the present invention.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

When a certain component (e.g., a first component) is described as being "coupled," "connected," or "joined" to another component (e.g., a second component) with or without the terms "functionally" or "communicatively" or "coupled" or "connected," this means that the certain component may be connected to another component directly (e.g., by wire or wirelessly) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

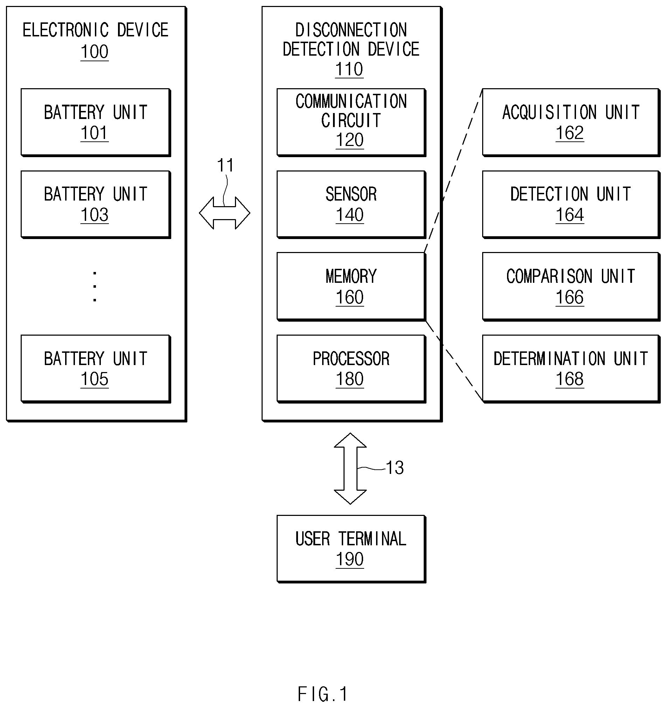

FIG. 1 is a block diagram of a disconnection detection device 110 according to one embodiment of the present disclosure.

Referring to FIG. 1, a disconnection detection device 110 may be connected to an electronic device 100 and a user terminal 190 by wire and/or wirelessly.

In one embodiment, a connection 11 between the disconnection detection device 110 and the electronic device 100 may be a communication connection via a wired and/or wireless network. In one embodiment, the wired network may be based on local area network (LAN) communication or powerline communication. According to one embodiment, the wireless network may be based on a short-range communication network (e.g., Bluetooth, WiFi, or IrDA) or a telecommunication network (a cellular network, a 4G network, or a 5G network).

In another embodiment, the connection 11 between the disconnection detection device 110 and the electronic device 100 may be a connection through an inter-device communication method between devices (e.g., a bus, a general purpose input and output (GPIO), a serial peripheral interface (SPI), or a mobile industry processor interface (MIPI)).

In one embodiment, a connection 25 between the disconnection detection device 110 and a user terminal 190 may be a communication connection via a wired and/or wireless network.

In one embodiment, the electronic device 100 may be a mobile device (e.g., a mobile phone, a laptop computers, a smart phone, or a smart pad), an electric vehicle (e.g., an electric vehicle (EV), a hybrid EV (HEV), a plug-in HEV (PHEV), or a fuel cell EV (FCEV)), an energy storage system (ESS), or a battery swapping system (BSS).

In one embodiment, the electronic device 100 may include one or more battery units 100, 102, and 104. Each of the one or more battery units 100, 102, and 104 may be a battery cell, a battery module, a battery pack, or a battery rack.

In one embodiment, the user terminal may be a mobile device (e.g., a mobile phone, a laptop computer, a smart phone, or a smart pad) or personal computer (PC).

In one embodiment, the disconnection detection device 110 may include a communication circuit 120, a sensor 140, a memory 160, and a processor 180. According to the embodiment, the disconnection detection device 110 illustrated in FIG. 1 may further include at least one component (e.g., a display, an input device, or an output device) other than the components illustrated in FIG. 1.

In one embodiment, the communication circuit 120 may establish a wired communication channel and/or a wireless communication channel between the disconnection detection device 110 and the electronic device 100 and/or the user terminal 190 and transmit and receive data with the electronic device 100 and/or the user terminal 190 through the established communication channel.

In one embodiment, the sensor 140 may acquire values related to states of the battery units 101, 103, and 105 of the electronic device 100. In one embodiment, the state-related values may represent one or more values of voltages, currents, resistances, states of charge (SOC), states of health (SOH), or temperatures of the battery units 101, 103, and 105, or a combination thereof. Hereinafter, the state-related value may be referred to as "state value."

In one embodiment, the memory 160 may include a volatile memory and/or a non-volatile memory.

In one embodiment, the memory 160 may store data used by at least one component (e.g., the processor 180) of the disconnection detection device 110. For example, the data may include software (or instruction related thereto), input data, or output data. In one embodiment, the instruction may allow the disconnection detection device 110 to perform operations defined by the instruction when executed by the processor 180.

In one embodiment, the memory 160 may include one or more software (e.g., an acquisition unit 162, a detection unit 164, a comparison unit 166, a determination unit 168, or a combination thereof).

In one embodiment, the processor 180 may include a central processing unit, an application processor, a graphics processing unit, a neural processing unit (NPU), an image signal processor, a sensor hub processor, or a communication processor.

In one embodiment, the processor 180 may control at least one another component (e.g., a hardware or software component) of the disconnection detection device 110 connected to the processor 180 by executing the software (e.g., the acquisition unit 162, the detection unit 164, the comparison unit 166, the determination unit 168, or the combination thereof) and perform various data processing or calculations.

Hereinafter, a method in which the disconnection detection device 110 detects whether the battery units 101, 103, and 105 are disconnected through the acquisition unit 162, the detection unit 164, the comparison unit 166, the determination unit 168, or a combination thereof will be described.

The acquisition unit 162 may acquire a charging profile of a battery. The acquisition unit 162 may acquire the charging profile of the battery acquired in a process of charging the battery. The acquisition unit 162 may acquire charging profiles of the battery acquired from C-rates. Here, the charging profile of the battery may be a voltage, current, or charging amount measured in the process of charging the battery, or a combination thereof.

The detection unit 164 may acquire relationship data. The detection unit 164 may acquire relationship data between voltage-capacity changes (dQ/dV). The detection unit 164 may acquire relationship data between the voltage-capacity changes (dQ/dV) based on the charging profile.

The detection unit 164 may detect a peak value. The detection unit 164 may detect the peak value based on the relationship data. The detection unit 164 may detect two or more peak values for each of the C-rates from the relationship data. Here, the peak value may be a maximum value or minimum value included in a capacity differential curve.

The comparison unit 166 may compare the peak value with a reference peak value. The comparison unit 166 may compare the two or more peak values with reference peak values. Here, the two or more peak values may be a first peak value, a second peak value, a third peak value, or a combination thereof.

The comparison unit 166 may compare the first peak value with a first reference peak value. The comparison unit 166 may compare the first peak value among the two or more peak values for each of the C-rates with the first reference peak value for each of the C-rates. Here, the first peak value may be a parasitic peak value. The parasitic peak value may be generated as the C-rate increases. The parasitic peak value may be generated at a predetermined C-rate or more. The parasitic peak value may be generated by a result of a decrease in the second peak value according to an increase in the C-rate. The first reference peak value may increase as the C-rate increases.

The comparison unit 166 may compare the second peak value with a second reference peak value. The comparison unit 166 may compare the second peak value among the two or more peak values for each of the C-rates with the second reference peak value for each of the C-rates. Here, the second peak value may be a peak value other than the parasite peak value. The second reference peak value may decrease as the C-rate increases.

The comparison unit 166 may compare the first peak value among the two or more peak values for each of the C-rates with the first reference peak value for each of the C-rates and compare the second peak value among the two or more peak values for each of the C-rates with the second reference peak value for each of the C-rates.

The comparison unit 166 may additionally compare the third peak value with a third reference peak value. The comparison unit 166 may compare the third peak value among the two or more peak values for each of the C-rates with the third reference peak value for each of the C-rates. Here, the third reference peak value may decrease as the C-rate increases.

The determination unit 168 may determine whether the battery is disconnected. The determination unit 168 may determine whether the battery is disconnected based on a result of the comparison. The determination unit 168 may determine whether the battery is disconnected based on a result of the comparison of the comparison unit 166.

When the first peak value is smaller than the first reference peak value, the determination unit 168 may determine that a disconnection has occurred in the battery. When the first peak value for each of the C-rates is smaller than the first reference peak value for each of the C-rates, the determination unit 168 may determine that a disconnection has occurred in the battery.

When the second peak value is greater than the second reference peak value, the determination unit 168 may determine that a disconnection has occurred in the battery. When the second peak value for each of the C-rates is greater than the second reference peak value for each of the C-rates, the determination unit 168 may determine that a disconnection has occurred in the battery.

When the first peak value for each of the C-rates is smaller than the first reference peak value for each of the C-rates and the second peak value for each of the C-rates is greater than the second reference peak value for each of the C-rates, the determination unit 168 may determine that a disconnection has occurred in the battery.

The determination unit 168 may determine whether a disconnection has occurred in the battery additionally based on a result of the additional comparison between the third peak value and the third reference peak value. The determination unit 168 may determine whether the battery is disconnected based on a result of the comparison and a result of the additional comparison. The determination unit 168 may determine whether the battery is disconnected based on a result of the comparison by the comparison unit 166 and finally determine whether the battery is disconnected additionally based on a result of the additional comparison by the comparison unit 166. When a result of the comparison represents a disconnection of the battery and the third peak value is greater than the third reference peak value, the determination unit 168 may finally determine that a disconnection has occurred in the battery.

The first reference peak value, second reference peak value, or third reference peak value described above may be a designated peak value. The first reference peak value, the second reference peak value, or the third reference peak value may be designated based on a battery and a C-rate of a reference battery.

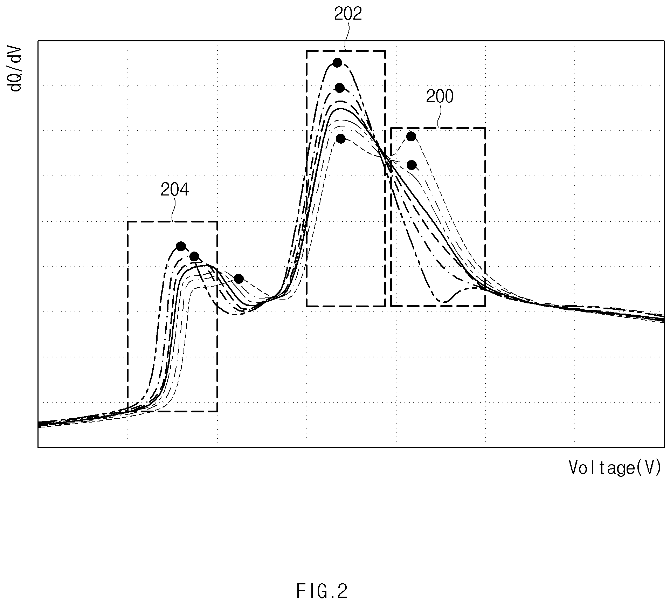

FIG. 2 illustrates a capacity change (dQ/dV) profile according to a voltage according to one embodiment of the present disclosure.

Referring to FIG. 2, there are capacity change curves according to voltages based on different C-rates.

The first peak value may be acquired in a first C-rate range 200. The first peak value may increase as the C-rate increases. The first peak value may be a parasitic peak value. The parasitic peak value may be generated as the C-rate increases. In other words, the parasitic peak value may be generated only at a predetermined C-rate or more.

The second peak value may be acquired in a second C-rate range 202. The second C-rate range 202 may include the first C-rate range 200. The second peak value may decrease as the C-rate increases. Due to the decrease in the second peak value according to the increase in the C-rate, the parasite peak value may be generated in the first C-rate range 200.

The third peak value may be acquired in a third C-rate range 204. The third peak value may decrease as the C-rate increases.

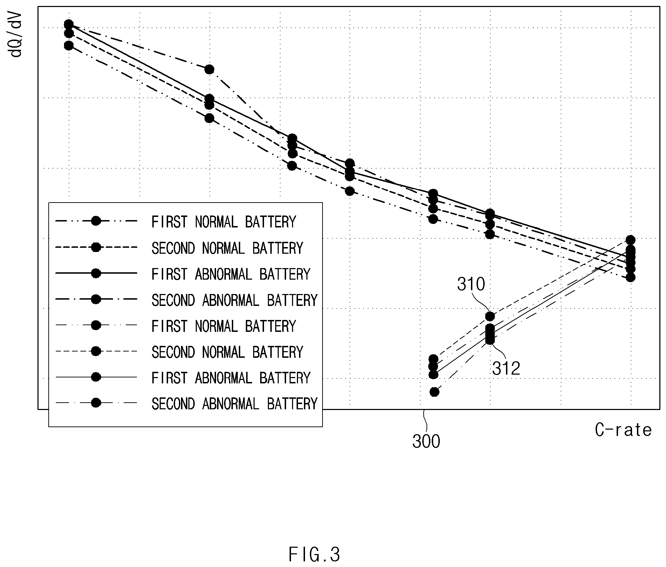

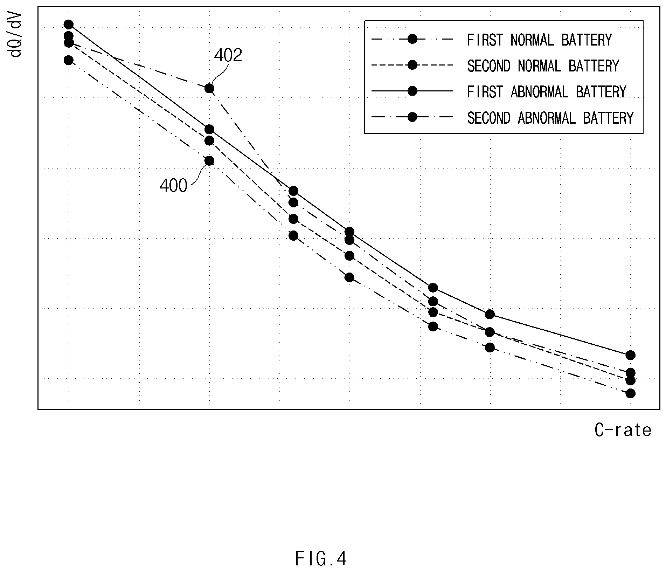

Hereinafter, a method in which the disconnection detection device 110 detects a disconnected abnormal battery based on a change in peak values of the capacity changes according to voltages based on the C-rates described above with reference to FIG. 2 will be described with reference to FIGS. 3 and 4.

FIG. 3 illustrates a first peak value and a second peak value of the capacity change (dQ/dV) profile according to a C-rate according to one embodiment of the present disclosure.

Referring to FIG. 3, the first peak value may be generated only at a predetermined C-rate 300 or more and may increase as the C-rate increases. The second peak value may be generated at all C-rates and may decrease as the C-rate increases.

A first normal battery or second normal battery may be a reference battery. The reference peak value may be designated based on a peak value of the reference battery. The following description will be made assuming that the first normal battery is the reference battery and a first peak value of the first normal battery is the first reference peak value.

The disconnection detection device 110 may compare a first peak value of a second abnormal battery with the first peak value of the first normal battery. The comparison unit 166 of the disconnection detection device 110 may compare the first peak value of the second abnormal battery with the first peak value of the first normal battery.

The determination unit 168 may determine whether the battery is disconnected. The determination unit 168 may determine whether the battery is disconnected based on a result of comparison of the comparison unit 166. The determination unit 168 may determine that a disconnection has occurred in the battery when a first peak value 312 of the second abnormal battery is smaller than a first peak value 310 of the first normal battery.

FIG. 4 illustrates a third peak value of a capacity differential (dQ/dV) profile according to the C-rate according to one embodiment of the present disclosure.

Referring to FIG. 4, the third peak value may be generated at all C-rates and may increase as the C-rate increases.

The first normal battery or second normal battery may be the reference battery. The reference peak value may be designated based on a peak value of the reference battery. The following description will be made assuming that the first normal battery is the reference battery and the third peak value of the first normal battery is the third reference peak value.

The disconnection detection device 110 may compare a third peak value of a second abnormal battery with the third peak value of the first normal battery. The comparison unit 166 of the disconnection detection device 110 may compare the third peak value of the second abnormal battery with the third peak value of the first normal battery.

The determination unit 168 may determine whether the battery is disconnected. The determination unit 168 may determine whether the battery is disconnected based on a result of additional comparison comparing the third peak value with the third reference peak value in addition to a result of comparison comparing the first peak value and/or the second peak value with the first reference peak value and/or the second reference peak value, respectively, by the comparison unit 166. When a result of the comparison represents a disconnection of the battery and the third peak value is greater than the third reference peak value, the determination unit 168 may finally determine that a disconnection has occurred in the battery.

The determination unit 168 may determine that a disconnection has occurred in the battery when a third peak value 402 of the second abnormal battery is greater than a third peak value 400 of the first normal battery. The determination unit 168 may determine that a disconnection has occurred in the battery when a result of comparison between the second abnormal battery and the first normal battery represents a disconnection of the battery and the third peak value 402 of the second abnormal battery is greater than the third peak value 400 of the first normal battery.

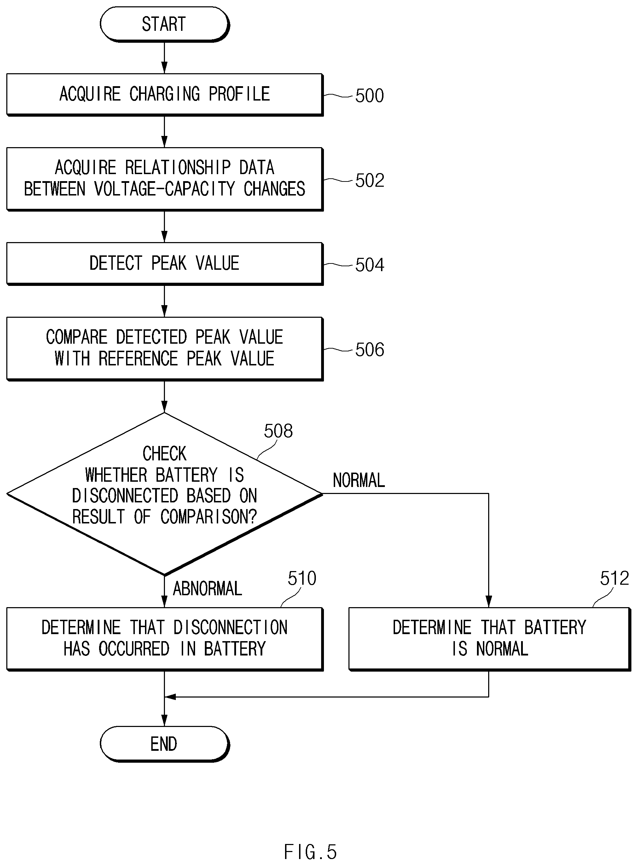

FIG. 5 is a flowchart illustrating a method of operating a disconnection detection device according to one embodiment of the present disclosure.

Referring to FIG. 5, in operation 500, the acquisition unit 162 may acquire the charging profile. The acquisition unit 162 may acquire the charging profile of the battery acquired in a process of charging the battery. The acquisition unit 162 may acquire the charging profiles of the battery acquired from different C-rates.

In operation 502, the detection unit 164 may acquire the relationship data. The detection unit 164 may acquire the relationship data between the voltage-capacity changes (dQ/dV). The detection unit 164 may acquire relationship data between the voltage-capacity changes (dQ/dV) based on the charging profile. Here, the relationship data between the voltage-capacity changes may be a graph of a capacity change according to a voltage.

In operation 504, the detection unit 164 may acquire the peak value. The detection unit 164 may detect the peak value based on the relationship data. The detection unit 164 may detect two or more peak values for each of the C-rates from the relationship data.

In operation 506, the comparison unit 166 may compare the peak value with the reference peak value. The comparison unit 166 may compare the two or more peak values with the reference peak values.

The comparison unit 166 may compare the first peak value with the first reference peak value. The comparison unit 166 may compare the first peak value among the two or more peak values for each of the C-rates with the first reference peak value for each of the C-rates.

The comparison unit 166 may compare the second peak value with the second reference peak value. The comparison unit 166 may compare the second peak value among the two or more peak values for each of the C-rates with the second reference peak value for each of the C-rates.

The comparison unit 166 may compare the first peak value among the two or more peak values for each of the C-rates with the first reference peak value for each of the C-rates and compare the second peak value among the two or more peak values for each of the C-rates with the second reference peak value for each of the C-rates.

The comparison unit 166 may additionally compare the third peak value with the third reference peak value. The comparison unit 166 may compare the third peak value among the two or more peak values for each of the C-rates with the third reference peak value for each of the C-rates.

In operation 508, the determination unit 168 may check (determine) whether the battery is disconnected. The determination unit 168 may check (determine) whether the battery is disconnected based on a result of comparison. The determination unit 168 may check (determine) whether the battery is disconnected. The determination unit 168 may check (determine) whether the battery is disconnected based on a result of the comparison. The determination unit 168 may check (determine) whether the battery is disconnected based on a result of the comparison of the comparison unit 166.

The determination unit 168 may check (determine) whether a disconnection has occurred in the battery additionally based on a result of the additional comparison between the third peak value and the third reference peak value. The determination unit 168 may check (determine) whether the battery is disconnected based on a result of the comparison and a result of the additional comparison. The determination unit 168 may check (determine) whether the battery is disconnected based on a result of the comparison by the comparison unit 166 and finally determine whether the battery is disconnected additionally based on a result of the additional comparison by the comparison unit 166.

In operation 510, when the first peak value is smaller than the first reference peak value, the determination unit 168 may determine that a disconnection has occurred in the battery. When the first peak value for each of different C-rates is smaller than the first reference peak value for each of different C-rates, the determination unit 168 may determine that a disconnection has occurred in the battery.

When the second peak value is greater than the second reference peak value, the determination unit 168 may determine that a disconnection has occurred in the battery. When the second peak value for each of the C-rates is greater than the second reference peak value for each of the C-rates, the determination unit 168 may determine that a disconnection has occurred in the battery.

When the first peak value for each of the C-rates is smaller than the first reference peak value for each of the C-rates and the second peak value for each of the C-rates is greater than the second reference peak value for each of the C-rates, the determination unit 168 may determine that a disconnection has occurred in the battery.

When the third peak value is greater than the third reference peak value, the determination unit 168 may determine that a disconnection has occurred in the battery. When a result of the comparison represents a disconnection of the battery and the third peak value is greater than the third reference peak value, the determination unit 168 may finally determine that a disconnection has occurred in the battery.

The terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present disclosure without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. A disconnection detection device comprising:
an acquisition unit configured to acquire charging profiles of a battery acquired from different C-rates;
a detection unit configured to acquire relationship data between voltage-capacity changes based on the charging profiles and detect two or more peak values for each of the C-rates from the relationship data;
a comparison unit configured to compare a first peak value among the two or more peak values for each of the C-rates with a first reference peak value for each of the C-rates and compare a second peak value among the two or more peak values for each of the C-rates with a second reference peak value for each of the C-rates; and
a determination unit configured to determine whether the battery is disconnected based on a result of the comparison of the comparison unit,
wherein the first reference peak value increases as the C-rates increase, and the second reference peak value decreases as the C-rates increase.

2. The disconnection detection device according to claim 1, wherein, when the first peak value for each of the C-rates is smaller than the first reference peak value for each of the C-rates and the second peak value for each of the C-rates is greater than the second reference peak value for each of the C-rates, the determination unit determines that a disconnection has occurred in the battery.

3. The disconnection detection device according to claim 1, wherein the first peak value is a parasitic peak value, and
the second peak value is a peak value other than the parasite peak value.

4. The disconnection detection device according to claim 1, wherein the two or more peak values for each of the C-rates further include a third peak value,
the comparison unit additionally compares the third peak value among the two or more peak values for each of the C-rates with a third reference peak value for each of the C-rates,
the determination unit determines whether the battery is disconnected additionally based on a result of additional comparison between the third peak value and the third reference peak value of the comparison unit, and
the third reference peak value decreases as the C-rates increase.

5. The disconnection detection device according to claim 4, wherein, when the result of the comparison represents a disconnection of the battery and the third peak value for each of the C-rates is greater than the third reference peak value for each of the C-rates, the determination unit determines that a disconnection has occurred in the battery.

6. The disconnection detection device according to claim 1, wherein the first peak value is acquired in a first C-rate range, and
the second peak value is acquired in a second C-rate range including the first C-rate range.

7. A disconnection detection method comprising:
an operation of acquiring charging profiles of a battery acquired from different C-rates;
an operation of acquiring relationship data between voltage-capacity changes based on the charging profiles;
an operation of detecting two or more peak values for each of the C-rates from the relationship data;
an operation of comparing a first peak value among the two or more peak values for each of the C-rates with a first reference peak value for each of the C-rates and comparing a second peak value among the two or more peak values for each of the C-rates with a second reference peak value for each of the C-rates; and
an operation of determining whether the battery is disconnected based on a result of the comparison by the operation of comparing,
wherein the first reference peak value increases as the C-rates increase, and the second reference peak value decreases as the C-rates increase.

8. The disconnection detection method according to claim 7, wherein, when the first peak value for each of the C-rates is smaller than the first reference peak value for each of the C-rates and the second peak value for each of the C-rates is greater than the second reference peak value for each of the C-rates, the determination unit determines that a disconnection has occurred in the battery.

9. The disconnection detection method according to claim 7, wherein the first peak value is a parasitic peak value, and
the second peak value is a peak value other than the parasite peak value.

10. The disconnection detection method according to claim 7, wherein the two or more peak values for each of the C-rates further include a third peak value,
the operation of comparing includes comparing the third peak value among the two or more peak values for each of the C-rates with a third reference peak value for each of the C-rates,
the operation of determining includes determining whether the battery is disconnected additionally based on a result of the additional comparison between the third peak value and the third reference peak value, and
the third reference peak value decreases as the C-rates increase.

11. The disconnection detection method according to claim 10, wherein, when the result of the comparison represents a disconnection of the battery and the third peak value for each of the C-rates is greater than the third reference peak value for each of the C-rates, the operation of determining includes determining that a disconnection has occurred in the battery.

12. The disconnection detection method according to claim 7, wherein the first peak value is acquired in a first C-rate range, and
the second peak value is acquired in a second C-rate range including the first C-rate range.
